Europäisches Patentamt

European Patent Office

Office européen des brevets

(19)

(11) Numéro de publication : **0 329 237 B1**

(12) # FASCICULE DE BREVET EUROPEEN

(45) Date de publication du fascicule du brevet :
**11.11.92 Bulletin 92/46**

(51) Int. Cl.$^5$ : **B41F 15/36,** H05K 3/12

(21) Numéro de dépôt : **89200325.2**

(22) Date de dépôt : **13.02.89**

(54) **Machine de sérigraphie.**

(30) Priorité : **19.02.88 FR 8801989**

(43) Date de publication de la demande :
**23.08.89 Bulletin 89/34**

(45) Mention de la délivrance du brevet :
**11.11.92 Bulletin 92/46**

(84) Etats contractants désignés :
**CH DE FR GB IT LI**

(56) Documents cités :
**US-A- 4 336 753**

(73) Titulaire : **PHILIPS CIRCUITS IMPRIMES**
**41, rue Pierre Brossolette**
**F-27016 Evreux (FR)**
(84) **FR**
Titulaire : **N.V. Philips' Gloeilampenfabrieken**
**Groenewoudseweg 1**
**NL-5621 BA Eindhoven (NL)**
(84) **CH DE GB IT LI**

(72) Inventeur : **Sorel, Alain Société Civile S.P.I.D.**
**209, rue de l'Université**
**F-75007 Paris (FR)**

(74) Mandataire : **Caron, Jean et al**
**Société Civile S.P.I.D. 156, Boulevard**
**Haussmann**
**F-75008 Paris (FR)**

EP 0 329 237 B1

Jouve, 18, rue Saint-Denis, 75001 PARIS

## Description

L'invention concerne une machine de sérigraphie pour imprimer un objet plan, munie d'un chassis supportant l'objet, d'un cadre supportant une toile-écran, de moyens pour déplacer ce cadre entre une position écartée de l'objet pour le chargement/déchargement de ce dernier et une position de travail dans laquelle la toile est pratiquement appliquée sur l'objet, d'une raclette mobile au dessus de la toile en position de travail, et de moyens pour déplacer le cadre en maintenant ce dernier dans un plan qui reste toujours à peu près parallèle au plan de l'objet, constitués de plusieurs mécanismes de montée/descente répartis le long de la périphérie du cadre.

Une machine selon le préambule ci-dessus est connue du document US-A-4 336 753. Cette machine est munie d'un chassis fixe sur lequel on pose une pièce à encrer. Le cadre rectangulaire supportant la toile écran est rigide et il est muni de mécanismes de montée/descente répartis le long de la périphérie du cadre pour, en position haute décharger/charger la machine et, en position basse procéder à la sérigraphie proprement dite. Elle est munie d'interrupteurs pour arrêter l'actionnement des mécanismes lorsqu'ils atteignent leur position basse. Cette machine sert à teindre des tissus, et de de ce fait une grande précision n'est pas nécessaire : c'est pourquoi elle n'est pas munie de moyens pour arrêter la descente du cadre dans une position précise ; lorsqu'il arrive en position basse, le cadre et la toile sont tout simplement laissés posés sur la pièce à traiter. Néanmoins des machines du même genre sont utilisées notamment dans l'industrie électronique pour la fabrication de circuits imprimés. Alors une beaucoup plus grande précision est nécessaire, ce qui est d'autant plus difficile à obtenir que les dimensions de la machine sont importantes. En outre un problème particulier est difficile à résoudre : lorsque la toile est en position de travail, un petit intervalle est nécessaire entre elle et le circuit à encrer de façon à ce qu'elle ne se colle pas sur lui. Une grande précision de la hauteur du cadre par rapport à l'objet est donc nécessaire.

L'invention fournit une machine qui présente une très grande précision pour la hauteur du cadre, du fait que la machine est munie d'un dispositif de détection précise d'une position particulière de la toile, constitué de plusieurs détecteurs de hauteur disposés chacun en face de la toile au voisinage d'un mécanisme de montée/descente, chacun de ces détecteurs commandant l'arrêt du mécanisme voisin, lorsque ce dernier est descendu à la hauteur voulue.

La machine fonctionne selon le processus suivant : un circuit à encrer étant en place sur le chassis fixe, la descente du cadre commence et lorsque le dispositif de détection constate que la toile est dans une position de référence, la descente s'arrête. Ainsi, une grande précision est obtenue pour la hauteur de la toile au-dessus du circuit.

Dans un mode de réalisation avantageux, les ensembles détecteur de hauteur/mécanisme de descente sont au nombre de quatre et situés chacun près d'un angle du cadre.

Aussi lors de la descente, dès qu'un angle du cadre a atteint sa hauteur de référence, la descente s'arrête pour cet angle, et continue pour les autres jusqu'à ce que, un par un, ils aient atteint chacun sa hauteur précise, chacun des quatre détecteurs de hauteur commandant le mécanisme de descente situé dans le même angle que lui. Avec un palpeur dans chaque angle, et le procédé de descente indiqué, le cadre peut sans inconvénient être déformable notamment par gauchissement, et donc sa construction est plus légère et plus économique, et il en est de même pour les mécanismes de montée/descente.

Une fois qu'une position précise en hauteur a été obtenue grâce à ces dispositifs, il est possible de retoucher la hauteur de l'ensemble d'une quantité déterminée sans perdre de précision. Les machines destinées aux circuits imprimés comportent une raclette, qui avance pour racler de l'encre sur la toile. Lorsque la raclette appuie sur la toile, celle-ci forme en arrière de la raclette un angle avec le circuit, appelé angle de décollement, et cet angle dépend de la distance entre la raclette et le bord du cadre ; de ce fait la constance des paramètres de la sérigraphie sur toute la surface du circuit est difficile à obtenir. Il est possible avec la machine selon l'invention d'agir de façon adaptée sur chacun des angles du cadre, notamment pour régler l'angle de décollement. A cet effet les mécanismes de montée/descente sont actionnés selon une cinématique programmable et qui est fonction de l'avance de la raclette pour régler l'angle de décollement de la toile.

L'obtention d'une cinématique complexe est facilitée lorsque la commande est faite au moyen d'un automate programmable, qui contient en mémoire les réglages particuliers pour chaque type de sérigraphie, et auquel sont amenées les données fournies par les capteurs de la machine, notamment celles des palpeurs de position de la toile, et la position de la raclette. Lorsque cet automate est lui-même piloté par un ordinateur, les possibilités de mémorisation de réglages et la souplesse d'utilisation sont encore améliorées.

Du fait de la très grande précision obtenue avec la machine selon l'invention, il n'est plus nécessaire de prévoir une élasticité au niveau de la raclette, élasticité qui était nécessaire dans l'art antérieur pour compenser un manque de précision de la position du cadre, auquel était fixée la raclette, et qui avait l'inconvénient que les paramètres de raclage étaient mal définis. On obtient donc une sérigraphie à haute définition avec la machine selon l'invention, du fait que, la raclette étant mûe par un mécanisme coulissant, celui-ci est fixé au chassis au lieu d'être fixé au cadre et que, durant le déplacement de la raclette sur la toile, sa hauteur par rapport à l'objet est fixe, au lieu de se définir d'elle même sous l'effet d'un ressort ou de son poids.

La grande précision obtenue avec la machine décrite ci-dessus offre en outre un avantage inédit. Alors que depuis longtemps on a expérimenté différentes astuces pour réaliser la métallisation de trous, par exemple en prévoyant une aspiration au travers desdits trous pour y entraîner de l'encre, avec la présente machine, il suffit de prévoir que la raclette comporte à sa partie inférieure une surface à peu près plane et inclinée par rapport au plan de la toile, et que son sens de déplacement soit tel que la partie la plus basse du plan incliné soit à l'arrière.

La description qui va suivre, en regard des dessins annexés décrivant des exemples non limitatifs, fera bien comprendre comment l'invention peut être réalisée.

La figure 1 est une représentation schématique en perspective des éléments essentiels d'une machine selon l'invention.

La figure 2 est un schéma de principe illustrant la définition de l'angle de décollement.

Les figures 3A et 3B représentent l'ensemble de la machine, respectivement vue de dessus et en bout.

La figure 4 représente en coupe un mécanisme de descente.

La figure 5 représente en coupe le mécanisme de déplacement de la raclette .

La figure 6 représente une section d'une raclette de l'art antérieur.

La figure 7 représente une section d'une raclette destinée à la réalisation de trous métallisés.

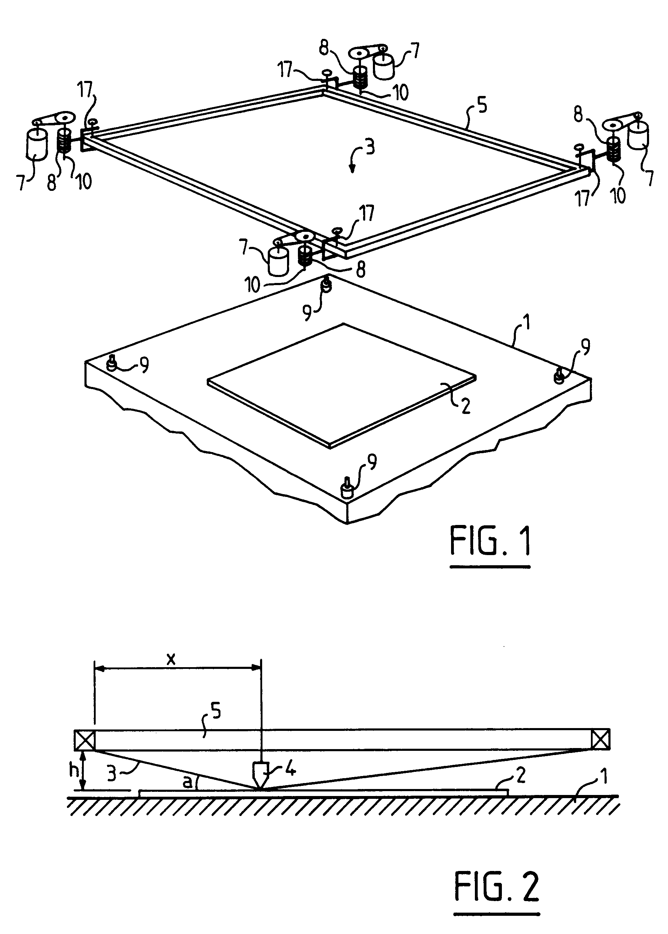

Sur la figure 1 sont représentés schématiquement un chassis 1 portant un circuit plan à encrer 2, et un cadre porte toile 5. Une toile 3 est tendue et collée sous le cadre 5.

Des moyens sont prévus pour que le cadre avec la toile puisse être soulevé pour le chargement ou le déchargement du circuit 2, et abaissé dans une position de travail. Ces moyens sont constitués par quatre vis verticales 10 dont la position en hauteur est fixe et qui entraînent chacune un écrou 8 fixé au cadre 5 au moyen d'une pince 17 près de chacun de ses quatre angles. Ces vis sont entraînées chacune en rotation par un moteur 7. La longueur des vis 10 est prévue pour que la toile en position basse puisse toucher le circuit 2, et qu'en position haute on puisse facilement retirer ce dernier et en placer un autre. Une telle machine peut traiter par exemple des circuits imprimés de format standard 65 x 53 cm. La différence de hauteur entre la position de chargement/déchargement et la position de travail est de l'ordre de quelques centimètres : c'est seulement pour permettre une vue plus claire des divers éléments que le cadre est représenté ici en hauteur au-dessus du chassis : en réalité il est situé juste au dessus, de façon que la toile 3 puisse être appliquée sur le circuit 2, lorsqu'elle est abaissée dans sa position de travail.

Il suffit que les quatre moteurs 7 tournent en synchronisme pour que le cadre soit déplacé en restant parallèle au plan de l'objet c'est-à-dire du circuit 2 et du chassis 1. Comme il sera expliqué plus loin, on introduit en fait volontairement des petites différences entre les mouvements des quatre moteurs.

Le chassis 1 est muni de quatre détecteurs de hauteur 9 qui détectent de façon précise une position particulière de la toile, à savoir la position où cette dernière touche les quatre détecteurs à la fois.

Selon un mode de réalisation préféré, ces détecteurs sont constitués chacun d'une électrode dont l'extrémité supérieure est située à une hauteur précise. La toile 3 étant métallique ou métallisée (par exemple une toile en polyester nickelé disponible dans le commerce) et reliée à une tension électrique, par exemple à la masse, elle vient établir un contact avec l'électrode lorsqu'elle la touche, ce qui permet la détection d'un courant électrique. On peut aussi prévoir deux électrodes à la même hauteur pour chaque détecteur, ces deux électrodes étant alors court-circuitées par la toile. On peut aussi prévoir des interrupteurs a commande par palpeur, mais la position exacte du palpeur qui déclenche la rupture (ou l'établissement) du courant n'est pas toujours définie avec une grande précision. On peut aussi utiliser un comparateur pneumatique (basé sur le fait que le cadre vient boucher un orifice débitant de l'air, du genre "comparateur SOLEX") ou un système de détection optique de position, dont il existe de nombreux modèles.

Chacun des détecteurs 9 est situé à proximité d'un des angles du cadre, et il en est de même des systèmes de montée/descente 7, 8, 10, 17.

Pendant la descente du cadre, dès que l'un des détecteurs 9 est actionné par l'arrivée à sa hauteur de la partie du cadre en face de laquelle il est situé, ce détecteur commande l'arrêt du moteur correspondant. L'arrêt du cadre est donc réalisé en quatre temps, angle par angle. Le cadre peut donc être relativement simple et léger, et est cependant positionné dans un plan parfaitement défini.

On pourrait imaginer de positionner les détecteurs 9 de manière à arrêter la toile à sa hauteur de travail, mais cette hauteur n'est pas constante, comme cela sera expliqué plus loin. On place donc ces détecteurs juste à la hauteur de la face supérieure du circuit 2. Le cadre est d'abord descendu jusqu'à obtenir les quatre contacts avec les détecteurs, et par la suite déplacé d'une petite quantité facilement contrôlable avec précision, pour l'amener à la hauteur de travail.

Chacun des moteurs 7 est un moteur à courant continu à codeur, c'est-à-dire muni d'un dispositif qui mesure sa rotation, et d'un asservissement qui permet, à partir de cette mesure, de commander un mouvement de rotation d'un nombre de tours ou de fractions de tour prédéterminé. Ceci permet d'obtenir la hauteur de travail désirée à partir de la position repérée par les détecteurs de position 9.

On pourrait imaginer facilement d'autres solutions équivalentes, par exemple : employer des moteurs pas à pas, ou remplacer le système vis-écrou 8, 10 par un système levier-biellette commandé par une vis sans fin actionnée par le moteur, pourvu que l'amplitude du mouvement puisse être commandée avec certitude.

Sur la figure 2 sont représentés schématiquement un cadre rectangulaire dont on voit un côté 5 et deux cotés perpendiculaires au plan du dessin, coupés et marqués d'un X. A ce cadre est collée une toile 3. Un chassis 1 supporte un circuit à encrer 2. Le cadre est légèrement surélevé par rapport au circuit 2, et une raclette 4 abaisse la toile 3 en la déformant jusqu'à toucher le circuit 2. La hauteur du cadre est exagérée sur le dessin, pour bien montrer l'angle "a" appelé angle de décollement. Cet angle a pour tangente la valeur h/x où h est la hauteur du cadre au-dessus du circuit, et x est la distance entre le côté gauche du cadre et la raclette 4. Lorsque x varie, l'angle "a" varie. Pour empêcher cet effet nuisible il faut faire varier h en même temps que x.

Avec le système selon l'invention, cette variation est facilement obtenue en commandant les moteurs 7, bien entendu à partir du positionnement particulier précis de la toile vis à vis des détecteurs de hauteur 9 qui a été d'abord obtenu. Cette commande des moteurs est réalisée sous le contrôle d'un automate programmable qui peut en outre être relié à un calculateur et auquel est amenée une donnée indiquant la position de la raclette 4. Grâce à la cinématique programmée ainsi obtenue on peut obtenir facilement un angle "a" idéal pour toute position de la raclette. La loi de commande utilisée peut être par exemple celle qui maintient constant le rapport h/x. Mais on peut aussi utiliser des lois plus complexes selon lesquelles le cadre est incliné, de façon que l'angle de la toile par rapport au circuit avant la raclette (l'équivalent de "a" de l'autre côté de la raclette) soit lui aussi maintenu constant. La loi de variation idéale dépend de plusieurs paramètres, dont la viscosité de l'encre, la hauteur initiale au départ de la raclette, la tension initiale de l'écran et la nature de la toile. Elle doit aussi être différente selon que l'on est en train de réaliser un nappage préalable de l'encre ou la sérigraphie proprement dite.

Deux mécanismes de montée/descente 7, 8, 10 situés sur une même ligne perpendiculaire à l'avance de la raclette sont actionnés alors en synchronisme pour maintenir l'angle de décollement, alors que les quatre mécanismes étaient actionnés indépendamment les uns des autres pour assurer le positionnement initial.

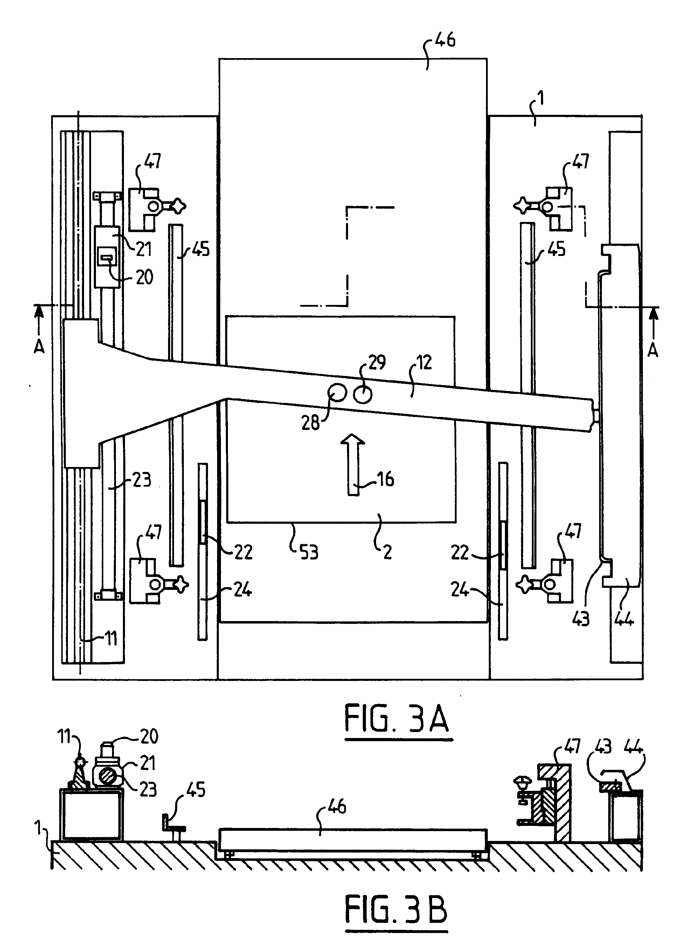

Sur les figures 3, 4 et 5, les organes déjà mentionnés ci-dessus portent toujours les mêmes références.

Sur le chassis 1 (figure 3A) est fixé un mécanisme coulissant constitué d'un d'un tube horizontal 11, sur lequel coulisse un bras 12, conduisant la raclette. Ce bras se déplace parallèlement au plan de la figure dans la direction indiquée par la flèche 16.

Il est mû au moyen d'un vérin sans tige, c'est-à-dire fait d'un piston mû par de l'huile à l'intérieur d'un tube 23, piston qui transmet magnétiquement son mouvement à un manchon 21 entourant le tube 23. Le tube 23 est placé parallèlement à côté du tube 11 support de coulissage et le bras 12 est accroché au manchon 21 par un doigt 20. Sur la figure le bras 12 est représenté à côté, pour permettre de voir le manchon 21 ; il est bien évident qu'en fonctionnement le bras 12, qui est entraîné par le doigt 20, est situé au dessus de lui. Le bras est guidé à son autre extrémité, à droite sur la figure, par une barre 43, protégée par un carter 44. La vitesse de déplacement peut être ajustée par réglage du débit d'huile dans le vérin 23. Des dispositifs de mesure de la vitesse et de la position du bras sont prévus. A partir de la position, l'automate commande les moteurs élévateurs du cadre pour régler l'angle de décollement.

Le chassis 1 porte un tiroir 46 représenté très schématiquement, qui permet d'amener et d'enlever le circuit imprimé à encrer.

Lorsqu'un opérateur glisse en place le cadre 5 (qui n'est pas représenté pour alléger la figure) deux cornières 45 le supportent provisoirement, en attendant qu'il soit attaché aux quatre dispositifs de montée/descente 47.

La position de tous ces éléments (sauf le bras 12) est illustrée aussi par la vue en bout de la figure 3B qui est une coupe le long de la ligne AA de la figure 3A.

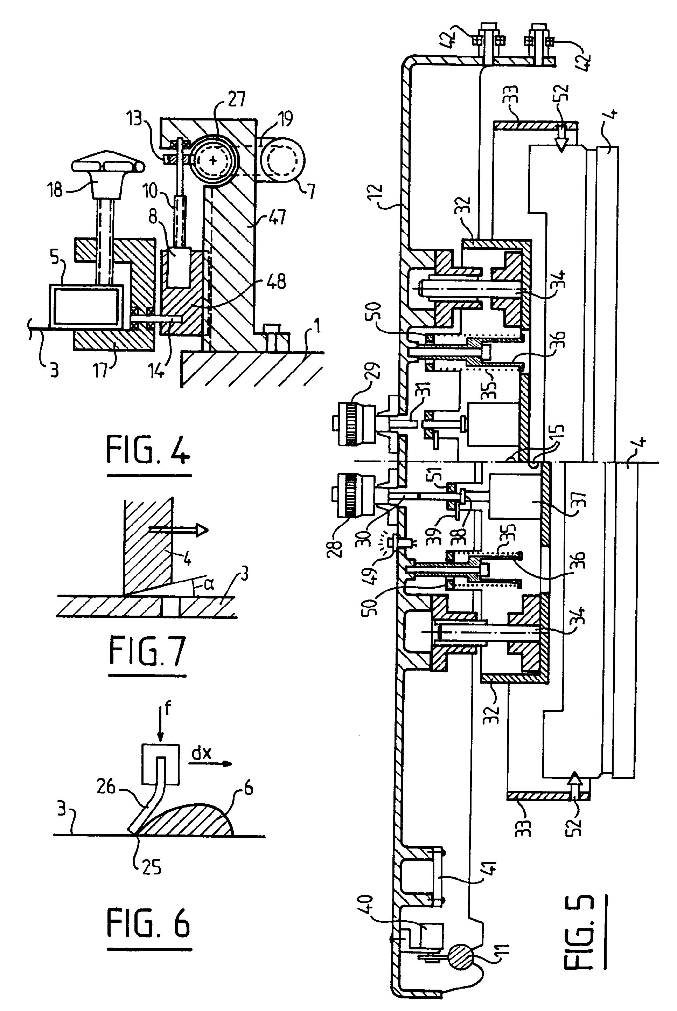

Un mécanisme de montée/descente est représenté plus en détail et en coupe, sur la figure 4. Une colonne 47 porte le moteur 7. Sur cette colonne coulisse verticalement une pièce 48 solidaire de l'écrou 8, dans lequel est vissée la tige filetée 10. Celle-ci est entraînée en rotation par un couple roue dentée 13, vis sans fin 27. Cette dernière est entraînée par le moteur 7 au moyen d'un courroie 19. Un étrier 17 est fixé par un axe 14 à la pièce 48. L'axe 14 permet à l'étrier de pivoter lorsque le cadre est incliné pour ajuster l'angle de décollement.

Une vis avec un bouton moleté 18 permet le blocage du cadre 5 dans l'étrier 17.

Le bras 12 est représenté plus en détail et en coupe sur la figure 5. Il comporte un corps principal 12, une pièce intermédiaire 32, et une pièce support de raclette 33.

Le corps principal 12 coulisse sur le tube 11, (perpendiculaire au plan du dessin) et est guidé à l'autre extrémité par deux roulettes 42 à billes qui roulent de part et d'autre de la barre 43 de la figure 3B. Une plaque 41 vient s'accoupler avec le doigt 20 (figure 3B) du vérin hydraulique pour entraîner le bras. Un élément de mesure 40 fixé au corps 12 est muni d'une roue qui roule sur le tube 11 pour mesurer la vitesse du déplacement du bras, et sa position. Ceci permet de réguler la vitesse qui doit être différente selon le type de sérigraphie. La position est transmise à l'automate pour la commande de l'angle de décollement.

La pièce intermédiaire 32 est représentée en position basse pour ce qui est de sa moitié à gauche sur le dessin, et en position haute pour sa moitié droite. Elle porte deux axes verticaux 34 qui glissent dans les manchons à billes fixés au corps 12. La pièce 32 est donc guidée en translation verticale vis à vis du corps 12.

Deux ressorts 35 s'appuyant chacun à leur extrémité inférieure sur une pièce 36 attachée au corps 12, et à leur extrémité supérieure sur une barrette 50 reliée à la pièce 32, repoussent la pièce intermédiaire 32 vers le haut. En opposition à ces ressorts, un vérin 37 à tige est fixé sur la pièce intermédiaire 32. Sa tige traverse une barrette 51 liée à la pièce intermédiaire 32 et appuie sur la tige 30 d'une butée micrométrique 28, pour faire descendre la pièce intermédiaire 32. Un autre vérin identique appuie sur la tige 31 d'une butée micrométrique 29. Un seul de ces deux vérins est utilisé à la fois, et ils sont situés suffisamment près du centre pour que l'action d'un seul des deux ne mette pas la pièce 32 en porte-à-faux.

La tige du vérin porte une collerette 38 qui vient toucher un élément de contact électrique 39 porté par la barrette 51 lorsqu'elle arrive en fin de course. Ce contact commande l'arrêt du vérin, et aussi l'allumage d'un voyant lumineux 49.

La raclette 4 est montée pivotante autour de pointeaux 52 fixés à la pièce support de raclette 33, laquelle est accrochée uniquement en son centre à la pièce intermédiaire 32 au moyen d'un axe 15 parallèle au plan du circuit imprimé et perpendiculaire à la raclette. Cet axe permet un pivotement de la pièce 33 et donc de la raclette 4.

La disposition particulière du vérin 37 permet un ajustage aisé de la hauteur de raclette en procédant de la façon suivante : un circuit et une toile étant en position de travail, on fait descendre l'ensemble des pièces 32, 33 jusqu'à ce qu'il arrive en butée basse, c'est-à-dire que la collerette 38 touche le contact 39 et la lampe 49 s'allume. On suppose qu'alors la raclette 4 ne touche pas encore la toile. Alors on tourne à la main le bouton de la butée micrométrique 28 jusqu'à appuyer sur la tige du vérin 37 et faire descendre l'ensemble. Lorsqu'il arrive en contact avec la toile supportée par le circuit imprimé, il ne peut plus continuer à descendre. Alors la tige du vérin 37 commence à rentrer dans le vérin et la collerette 38 quitte le contact 39, éteignant la lampe. On sait alors qu'on est dans la position de référence où la raclette est appuyée sur la toile. A partir de cette position on peut apporter un écart différentiel réglable à volonté au moyen des graduations de la butée micrométrique. Pour l'ensemble de ce processus, on utilise une pression d'huile très réduite dans le vérin 37, de façon à ne pas risquer d'endommager la toile.

L'un des deux couples vérin-butée micrométrique est utilisé pour le nappage, et l'autre pour la sérigraphie proprement dite.

Les raclettes de l'art antérieur (figure 6), du fait de l'absence de précision relative entre le cadre et le chassis, étaient fixées au cadre et appuyées vers le bas avec une force f définie, et munies d'une partie raclante 26 élastique, agissant un peu comme les soies d'un pinceau pour pousser (vers la droite sur la figure) le tas d'encre 6 sur la toile 3. De ce fait il était impossible de fixer la position exacte de l'arête raclante 25, et les paramètres de la sérigraphie étaient mal contrôlés.

La grande précision du positionnement du cadre vis à vis du chassis dans la machine selon l'invention autorise au contraire la fixation de la raclette 4 à une hauteur imposée au-dessus du chassis. La raclette est elle-même rigide de façon qu'une définition précise de la position verticale de la ligne d'appui de la raclette sur la toile soit assurée. La partie inférieure de la raclette 4 est réalisée un caoutchouc dur.

Le basculement de la raclette avec recul de l'arête raclante vers l'arrière par rapport à son sens d'avance est possible grâce à la fixation par les pointeaux 52 de la figure 5. Des vérins non représentés, fixés à la partie 33, maintiennent la raclette 4 verticale tout en permettant un éventuel échappement par basculement au cas où la raclette rencontrerait un obstacle imprévu. Néanmoins cette possibilité est prévue uniquement pour des raisons de sécurité, mais ne joue aucun rôle en fonctionnement normal.

La raclette 4 est placée en biais par rapport à sa direction de déplacement 16, du fait que le bras 12 (figure 3) n'est pas tout à fait perpendiculaire au tube 11. Il forme avec la perpendiculaire au tube 11 un angle d'environ 5°.

La position en biais de la raclette facilite le passage de celle-ci sur le bord 53 du circuit imprimé (figure 3A) au moment où la raclette y parvient, lors de son mouvement à partir de sa position de départ (non représentée) en bas de la figure 3A.

Du fait de cette position en biais, lors du déplacement dans la direction 16 l'extrémité gauche de la raclette atteint le bord 53 en premier ce qui risque d'entraîner un basculement de la raclette. Pour éviter cela, des semelles 22 mobiles dans le sens vertical sont positionnées dans le chassis de façon à soutenir la raclette lorsqu'elle n'est plus au dessus du circuit 2, la face supérieure de ces semelles était à la même hauteur que celle du circuit.

Des semelles semblables (non représentées) sont aussi disposées le long du bord opposé du circuit 2, là où la raclette quitte le circuit. Les semelles 22 débouchent au-dessus du chassis au travers d'orifices allongés 24 ce qui autorise un coulissage horizontal qui permet une adaptation à différentes dimensions de circuits.

Le positionnement vertical des semelles 22 est obtenu au moyen d'un ressort de faible force, et d'un frein électrique ou pneumatique, qui bloque la semelle. Lorsque la toile est descendue contre le circuit, on laisse remonter la semelle 22 qui se positionne en s'appuyant sur la toile 3 sous l'effet du ressort, puis on la bloque à cette position au moyen du frein. Au lieu d'appuyer la semelle sur la toile, on peut aussi poser une règle sur le circuit 2, règle qui dépasse en dehors du circuit au-dessus des semelles, et qui est enlevée après blocage du frein.

Différents degrés d'automatisation peuvent être envisagés : à partir de la lecture d'un code de type de pièce, l'automate assisté d'un ordinateur peut par exemple avoir en mémoire un "savoir faire" qui comporte : la vitesse d'avance du bras pour le nappage et celle pour le raclage, la hauteur d'écran, une quinzaine de points de la courbe de relevage d'écran, entre lesquels il calcule une interpolation, pour le réglage de l'angle de décollement, et même la hauteur de raclette pour le raclage et le nappage, si on remplace les butées micrométriques manuelles 28, 29 par des butées à moteur codeur.

L'opérateur a seulement à mettre en place le circuit sur le tiroir 46, après quelques opérations initiales telles que la mise en place de l'écran, le montage d'une raclette de dureté appropriée, le réglage de position des semelles 22.

Le tiroir 46 permet le chargement/déchargement du circuit, le cadre 5 étant relevé de quelques centimètres seulement. On pourrait aussi utiliser des courroies transporteuses passant sur le chassis, qui seraient escamotées dans des saignées pendant la sérigraphie.

Pour réaliser la métallisation de trous, la raclette comporte à sa partie inférieure une surface à peu près plane et inclinée par rapport au plan de la toile, et son sens de déplacement est tel que la partie la plus basse du plan incliné est à l'arrière. Ainsi, lors de l'avance de la raclette, l'encre est poussée vers le bas dans les trous. Ceci est illustré à la figure 7 où la raclette 4 se déplace dans le sens de la flèche et sa section inférieure est un plan incliné faisant un angle $\alpha$ avec la toile 3. Bien entendu l'angle $\alpha$ et la vitesse du déplacement horizontal de la raclette sont à ajuster en fonction de la géométrie des pièces. Avec, par exemple, un circuit d'épaisseur 0,8mm, des trous de diamètre 0,6mm et une encre d'une viscosité de 100 centipoises, un angle $\alpha$ de 13° et une vitesse de raclette de 14cm/sec donnent les meilleurs résultats. Avec une épaisseur de 1,6mm et des trous de diamètre 0,8mm, un angle de 10° est préférable, avec la même vitesse. La même raclette est utilisée dans la direction de déplacement inverse, pour réaliser le nappage.

## Revendications

1. Machine de sérigraphie pour imprimer un objet plan, munie d'un chassis (1) supportant l'objet, d'un cadre (5) supportant une toile-écran (3), de moyens pour déplacer ce cadre entre une position écartée de l'objet pour le chargement/déchargement de ce dernier et une position de travail dans laquelle la toile est pratiquement appliquée sur l'objet, d'une raclette (4) mobile au dessus de la toile (3) en position de travail, et de moyens pour déplacer le cadre en maintenant ce dernier dans un plan qui reste toujours à peu près parallèle au plan de l'objet, constitués de plusieurs mécanismes de montée/descente répartis le long de la périphérie du cadre, caractérisée en ce que la machine est munie d'un dispositif de détection (9) précise d'une position particulière de la toile (3) constitué de plusieurs détecteurs de hauteur (9) disposés chacun en face de la toile (3) au voisinage d'un mécanisme de montée/descente (7,8,10) et en ce que chacun de ces détecteurs (9) commande l'arrêt du mécanisme (7,8,10) voisin, lorsque ce dernier est descendu à la hauteur voulue.

2. Machine selon la revendication 1, caractérisée en ce que, le cadre (5) étant rectangulaire, les ensembles détecteur de hauteur/mécanisme de descente (7,8,10) sont au nombre de quatre et situés chacun près d'un angle du cadre (5).

3. Machine selon la revendication 1, caractérisée en ce que, après qu'ils aient d'abord pris la susdite hauteur voulue, les mécanismes de montée/descente (7,8,10) sont actionnés selon une cinématique programmable qui est fonction de l'avance de la raclette (4), pour régler l'angle de décollement (a) de la toile (3).

4. Machine selon la revendication 3, caractérisée en ce que les mécanismes de montée/descente (7,8,10) sont commandés par un automate programmable.

5. Machine selon la revendications 4, caractérisée en ce que l'automate est piloté par un ordinateur.

6. Machine selon l'une quelconque des revendications 1 à 5, caractérisée en ce que chacun des mécanismes de montée/descente (7,8,10) est mû par un moteur (7) à courant continu à codeur.

7. Machine selon l'une quelconque des revendications 1 à 6, dont la raclette (4) est mûe par un mécanisme coulissant, caractérisée en ce que ce mécanisme est fixé au chassis (1), et en ce que, durant le déplacement de la raclette (4) sur la toile (3), sa hauteur d'appui sur la toile est fixée par rapport au chassis.

8. Machine selon la revendication 7, caractérisée en ce que la raclette (4) est fixée uniquement en son centre, et la raclette (4) est pivotante en ce point autour d'un axe parallèle au plan de l'objet et à peu près perpendiculaire à la raclette (4).

9. Machine selon la revendication 8, caractérisée en ce que la raclette (4) est placée en biais par rapport à la perpendiculaire à sa direction de déplacement, et en ce que des semelles mobiles (22) dans le sens vertical sont positionnées de façon à soutenir la raclette (4) lorsqu'elle n'est plus au-dessus de l'objet, la face supérieure de ces semelles étant à la même hauteur que celle de l'objet.

10. Machine selon l'une quelconque des revendications 7 à 9, utilisée pour la sérigraphie de pistes électriquement conductrices sur un circuit imprimé, caractérisée en ce que, afin de réaliser des trous métallisés en même temps que les pistes, la raclette (4) comporte à sa partie inférieure une surface à peu près plane et inclinée par rapport au plan de la toile (3), et son sens de déplacement est tel que la partie la plus basse du plan incliné soit à l'arrière.

**Patentansprüche**

1. Siebdruckmaschine zum Bedrucken eines flachen Gegenstands, mit einer Halterung (1) zum Unterstützen des Gegenstands, mit einem Rahmen (5) zum Unterstützen eines Drahtgewebes (3), mit Mitteln zum Verschieben dieses Rahmens zwischen einer vom Gegenstand getrennten Stellung zum Vorschieben/Entfernen des Gegenstands und einer Arbeitsstellung, in der das Gewebe tatsächlich auf den Gegenstand gelegt wird, mit einer über dem Gewebe (3) in der Arbeitsstellung bewegbaren Rakel (4), und mit Mitteln zum Bewegen des Rahmens, der gleichzeitig in einer Ebene immer ungefähr parallel zur Ebene des Gegenstands gehalten wird, wobei diese Mittel aus mehreren Anhebe/Absenkeinrichtungen bestehen, die auf dem Umfang des Rahmens verteilt sind, dadurch gekennzeichnet, daß die Maschine mit einer Anordnung (9) zum genauen Detektieren einer besonderen Stellung des Gewebes (3) ausgerüstet ist, die aus mehreren Höhendetektoren (9) besteht, die je gegenüber dem Gewebe (3) in der Nähe einer Anhebe/Absenkeinrichtung (7, 8, 10) angeordnet sind, und daß jeder dieser Detektoren (9) das Einstellen der benachbarten Einrichtung (7, 8, 10) steuert, wenn letztere nach der gewünschten Höhenstellung abgesunken ist.

2. Maschine nach Anspruch 1, dadurch gekennzeichnet, daß der Rahmen rechteckig ist, daß es vier Einheiten der Höhendetektor/Absenkeinrichtungen (7, 8, 10) gibt, und diese vier je in der Nähe einer Ecke des Rahmens (5) angeordnet sind.

3. Maschine nach Anspruch 1, dadurch gekennzeichnet, daß die Anhebe/Absenkeinrichtungen (7, 8, 10) nach dem anfänglichen Annehmen der vorgenannten gewünschten Höhe entsprechend programmierbarer Kinematik aktiviert werden, die eine Funktion der Näherung der Rakel (4) ist, um den Ablösewinkel (a) des Gewebes (3) einzustellen.

4. Maschine nach Anspruch 3, dadurch gekennzeichnet, daß die Anhebe/Absenkeinrichtungen (7, 8, 10) durch einen programmierbaren Automaten gesteuert werden.

5. Maschine nach Anspruch 4, dadurch gekennzeichnet, daß der Automat von einem Computer gesteuert wird.

6. Maschine nach einem oder mehreren der Ansprüche 1 bis 5, dadurch gekennzeichnet, daß jede der Anhebe/Absenkeinrichtungen (7, 8, 10) mit Hilfe eines Gleichstrommotors (7) mit einem Coder angetrieben wird.

7. Maschine nach einem oder mehreren der Ansprüche 1 bis 6, von der die Rakel mit einem Schlitten angetrieben wird, dadurch gekennzeichnet, daß dieser Schlitten auf der Halterung (1) befestigt ist, und daß bei der Bewegung der Rakel (4) über das Gewebe (3) ihre Traghöhe auf dem Gewebe in bezug auf die Halterung fixiert wird.

8. Maschine nach Anspruch 7, dadurch gekennzeichnet, daß die Rakel nur in ihrer Mitte festgesetzt wird, und daß die Rakel (4) in diesem Punkt um eine Achse parallel zur Ebene des Gegenstands und ungefähr senkrecht zur Rakel (4) scharnierbar ist.

9. Maschine nach Anspruch 8, dadurch gekennzeichnet, daß die Rakel (4) schräg in bezug auf die Senkrechte auf ihre Bewegungsrichtung angeordnet ist, und daß die Zwischenscheiben (22) in der vertikalen Richtung bewegbar und derart positioniert sind, daß sie die Rakel (4) tragen, wenn sie sich nicht länger über dem Gegenstand befindet, wobei die obere Fläche dieser Zwischenscheiben auf gleicher Höhe mit dem Gegenstand befinden.

10. Maschine nach einem der Ansprüche 7 bis 9, zur Verwendung zum Siebdrucken elektrisch leitender Spuren auf einer Druckverdrahtungsschaltung, dadurch gekennzeichnet, daß zum Durchkontaktieren von Löchern gleizeitig mit den Spuren die Rakel (4) in ihrem unteren Teil eine ungefähr ebene Oberfläche besitzt, die in bezug auf die Ebene des Gewebes (3) geneigt ist, und ihre Bewegungsrichtung derart ist, daß der untere Teil der geneigten Ebene sich an der Rückseite befindet.

## Claims

1. A silk screen printing machine for printing a plane article, equipped with a mounting (1) supporting the article, with a frame (5) supporting a screen cloth (3), with means for moving this frame between a position away from the article for loading/unloading of the latter and a working position in which the cloth is virtually laid against the article, with a doctor (4) movable above the cloth (3) in the working position, and with means for moving the frame whilst at the same time keeping the latter in a plane which always remains approximately parallel to the plane of the article, which means consist of several raising/lowering mechanisms distributed along the periphery of the frame, characterized in that the machine is equipped with a device (9) for the exact detection of a particular position of the cloth (3) consisting of several height detectors (9), each arranged opposite the cloth (3) in the vicinity of a raising/lowering mechanism (7, 8, 10), and in that each of these detectors (9) commands the stopping of the adjacent mechanism (7, 8, 10) when the latter has descended to the desired height.

2. A machine as claimed in Claim 1, characterized in that, the frame being rectangular, there are four height-detector/lowering-mechanism assemblies (7, 8, 10), and these are each located near a comer of the frame (5).

3. A machine as claimed in Claim 1, characterized in that the raising/lowering mechanisms (7, 8, 10), after they have first assumed the above-mentioned desired height, are actuated according to programmable kinematics which are a function of the advance of the doctor (4), in order to adjust the breakaway angle (a) of the cloth (3).

4. A machine as claimed in Claim 3, characterized in that the raising/lowering mechanisms (7, 8, 10) are controlled by a programmable robot.

5. A machine as claimed in Claim 4, characterized in that the robot is controlled by a computer.

6. A machine as claimed in any one of Claims 1 to 5, characterized in that each of the raising/lowering mechanisms (7, 8, 10) is actuated by means of a direct-current motor (7) with an encoder.

7. A machine as claimed in any one of Claims 1 to 6, of which the doctor (4) is actuated by means of a sliding mechanism, characterized in that this mechanism is fastened to the mounting (1), and in that during the movement of the doctor (4) over the cloth (3) its bearing height on the cloth is fixed relative to the mounting.

8. A machine as claimed in Claim 7, characterized in that the doctor (4) is fastened solely at its centre, and at this point the doctor (4) is pivotable about an axis parallel to the pane of the article and approximately perpendicular to the doctor (4).

9. A machine as claimed in Claim 8, characterized in that the doctor (4) is arranged obliquely relative to the perpendicular to its direction of movement, and in that sole pieces (22) movable in the vertical direction are positioned so as to support the doctor (4) when it is no longer above the article, the upper face of these sole pieces being at the same height as the article.

10. A machine as claimed in any one of Claims 7 to 9, used for silk screen printing of electrically conductive tracks on a printed circuit, characterized in that, in order to make metallized holes at the same time as the tracks, the doctor (4), in its lower part, has an approximately plane surface inclined relative to the plane of the cloth (3), and its direction of movement is such that the lowest part of the inclined plane is at the rear.

FIG. 1

FIG. 2

FIG. 3A

FIG. 3B

FIG. 4

FIG. 7

FIG. 6

FIG. 5